# EUROPEAN PATENT SPECIFICATION

(11) **EP 0 650 190 B1**
(45) Date of publication and mention of the grant of the patent: **04.10.2000**
(21) Application number: 94113502.2
(22) Date of filing: 30.08.1994
(51) Int. Cl.: H01L 21/84, H01L 29/78, H01L 23/552

(54) **Single event upset hardening of commercial VLSI technology without circuit redesign**
Abhärtung gegen die Auslösung von Einzelereignissen für die VLSI-Technologie ohne die Schaltungen neu zu gestalten
Durcissement contre les événements à déclenchement unique dans la technologie VLSI sans redessiner les circuits

(30) Priority: 26.10.1993 US 141505
(43) Date of publication of application: 26.04.1995
(73) Proprietor: International Business Machines Corporation, Armonk, N.Y. 10504 (US)
(72) Inventor: Brady, Frederick T., Chantilly, Virginia 22202 (US); Haddad, Nadim F., Oakton, Virginia 22124 (US); Edenfeld, Arthur R., Middlebrook, Virginia 24459 (US); Seliskar, John J., Centreville, Virginia 22020 (US); Wang, Li Kong, Montvale, New Jersey 07645 (US); Spencer, Oliver, Manassas, Virginia 22111 (US)
(74) Representative: Szynka, Dirk

(56) References cited:
- EP-A- 0 217 307
- EP-A- 0 474 289
- WO-A-89/04550
- US-A- 4 091 527
- US-A- 5 104 818
- IEEE TRANSACTIONS ON ELECTRON DEVICES, vol.39, no.3, March 1992, NEW YORK US pages 640 - 647 A. KAMGAR ET AL

## Description

### BACKGROUND OF THE INVENTION

### 1. Field of the Invention

This invention relates to VLSI circuits and more particularly to radiation hardening of VLSI circuits without redesign.

### 2. Background of the Invention

Satellite-based integrated circuits are under constant ombardment from the very high energy particles and photons that are found in the outer atmosphere and in space. When impacting an integrated circuit, these particles can generate a local error, known as a single event upset (SEU). Additionally, as VLSI circuits increase in complexity and transistors sizes are reduced, even earth-bound integrated circuits are susceptible to SEU from background sources.

Typically, circuits are hardened against SEU by redesign such that the transistor diffusion areas are much larger thereby increasing the amount of capacitance that must be discharged in order to cause an upset and/or adding resistors to slow down any transient response. While effective in increasing SEU resistance, redesigning of circuits has certain drawbacks. These drawbacks include a loss in circuit speed, particularly with resistors operating at low temperatures and a loss of circuit density. Most importantly, the cost of redesigning a commercial chip set can be very expensive.

The manufacturing of semiconductor integrated circuits is an expensive and very competitive business. This is particularly true for the space product applications business, where relatively low volumes prohibit economies of scale. As a result,it is necessary to reduce costs without reducing quality. A large portion of the cost of producing very large scale integrated circuits (VLSI) is in the design of the chips. Thus, whenever possible, it is desirable to use existing design libraries. In general, this is the object of designing radiation hardened chips, where non-hardened designs are modified so as to meet the specifications required for a particular application. Still, even in this example, modifying the commercial design to comply with the SEU hardness expected in space products adds a significant cost to the product. In addition, circuit speed can be lost when resistors are added or when the original circuit design rules must be relaxed. Thus, a technology approach that eliminates the need for a redesign would add significant cost and performance savings in SEU hardened integrated circuits.

The publication IEEE Trans. on Electron Devices, volume 39, No. 3, 1992, pages 640-647; A. Kamgar et al., discloses CMOS devices in thin Si-films on SIMOX-wafers. In this document fully depleted SOI-structures are described. The final firm thickness of the crystaline silicon film is given with 1,340 Å. US-4,091,527 discloses N+ NN+ transistors with silicon film thicknesses of approximately 5,000 to 20,000 Å (10 Å = 1 nm). Further, reference is made to US-5,104,818 describing N-channel transistors in SOI-structures and mentioning a mesa-thickness of nominally 1,200 Å.

As commercial technology moves to ever smaller devices, memory cells are becoming increasingly susceptible to SEU upset simply from background radiation. Thus, an improvement in the SEU hardness of commercial technology is desirable.

Though an object of the present invention is to present a fabrication method whereby any commercial circuit can be taken and become SEU hardened simply by the fabrication process. No circuit redesign is required, nor is circuit performance degraded.

The object of the present invention are achieved by the method according to claim 1 and the obtained circuit according to claim 3.

### Summary of the Invention

The invention is based on fabricating commercial VLSI circuit designs on fully depleted, accumulation mode devices using SOI substrates. With SOI, the circuits are fabricated in a very thin silicon layer which is situated on top a buried oxide layer. The basic advantages of SOI are well understood. SEU happens when a highly energetic particle strikes the drain diffusion region of an important transistor. As it traverses the silicon film, the particles generate a very large number of electron-hole pairs. The excess carriers that escape recombination are collected by the drain. A sufficient charge is collected by the drain, and the drain discharges its initial charge. With conventional bulk silicon, the cross sectional area for collecting charge is essentially the depth of the N-Well, which is typically two micrometer. Using SOI, the depth of the active area is reduced to the thickness of the silicon film or on the order of < 0.1 micrometer. Thus, to the first order, hardness is achieved by reducing the amount of device silicon in the path of energetic particles.

A second requirement of the invention is the use of fully depleted devices. While SOI can be used to meet very high prompt dose requirements, previous integrated circuit designs have used partially depleted devices. Partially depleted devices have a thicker silicon film, and hence the body of the transistor is not depleted of carriers when off. To meet SEU hardness requirements, partially depleted devices require shorting strap from the transistor body to the source and/or special ground contacts to the body of the transistor. Thus, partially depleted SOI devices are not compatible with bulk integrated circuit designs.

Another requirement of the present invention is that accumulation mode devices be used. In accumulation mode devices, the N-Channel (P-Channel) devices are comprised of n+ (p+) source and drain and n- (p-) body, and p+ (n+) doped polysilicon gates.

In a conventional transistor, the body is the opposite dopant type of the source and drain. The accumulation mode device is used in order to maintain design compatibility with bulk silicon without performance degradation. When conventional transistor designs are implemented in bulk silicon, a very high body doping density must be used to achieve a bulk-like threshold voltage. This high doping density degrades the device performance parameters.

An optional embodiment of the present invention is the use of device engineering to increase the circuit power supply voltage to acceptable levels. At high power supply voltages, SOI circuits tend to have high standby leakage due to high electric field effects at the transistor level. By implementing conventional lightly doped drains as well as neutral impurity implants, high power supply voltages can be used. The device engineering part of the invention can be omitted for low voltage applications.

### Brief Description of the Drawings

Figure 1 is a sketch of an SOI structure showing enhanced SEU resistance.
Figure 2 is a table comparing bulk, enhancement mode and accumulation mode device characteristics.
Figures 3 through 6 show the processing steps of the present invention.
Figure 7 is a graph showing the results of radiation testing of devices made according to the present invention.

### Detailed Description of the Invention

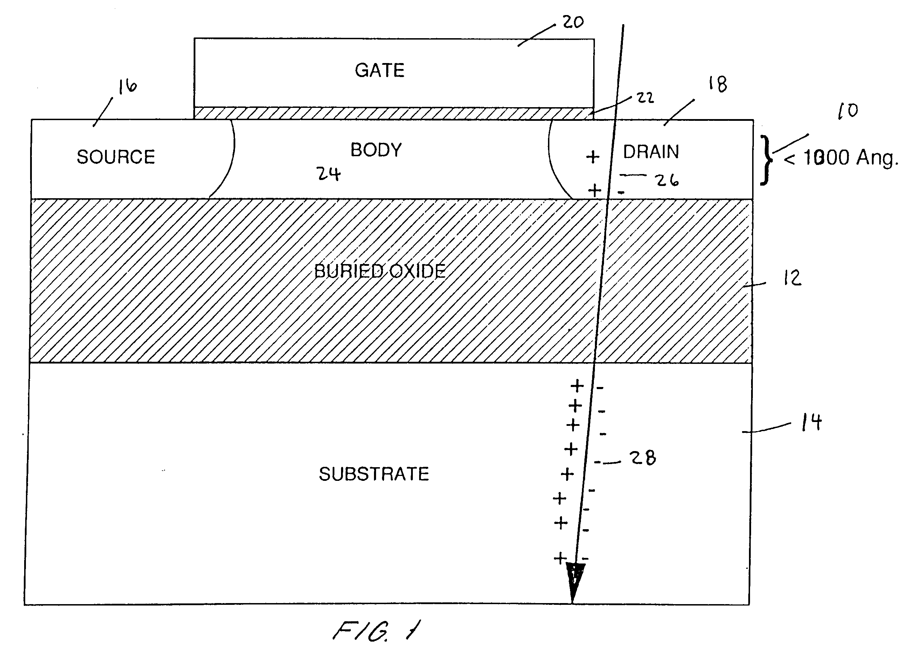

Figure 1 is a sketch of an SOI structure showing enhanced SEU resistance. The silicon-on-insulator structure has a silicon layer 10 of a thickness of 85 nm. This silicon layer is formed upon a buried oxide layer 12 which is situated on a substrate 14 which may be silicon or other carrier wafer for supporting the silicon-on-insulator layers. Into this SOI structure a transistor is formed having source region 16, drain region 18, gate 20 with a gate oxide 22. A channel region of the device is formed in the body 24. Because of the reduced cross sectional area, a charge particle can only generate charge through the 10 device region picking up very little charge as shown 26 before the particle goes through the buried insulating oxide and into the substrate which, can create additional charges 28 but these charges 28 will not have an effect on a transistor device because of the intervening buried oxide layer 12.

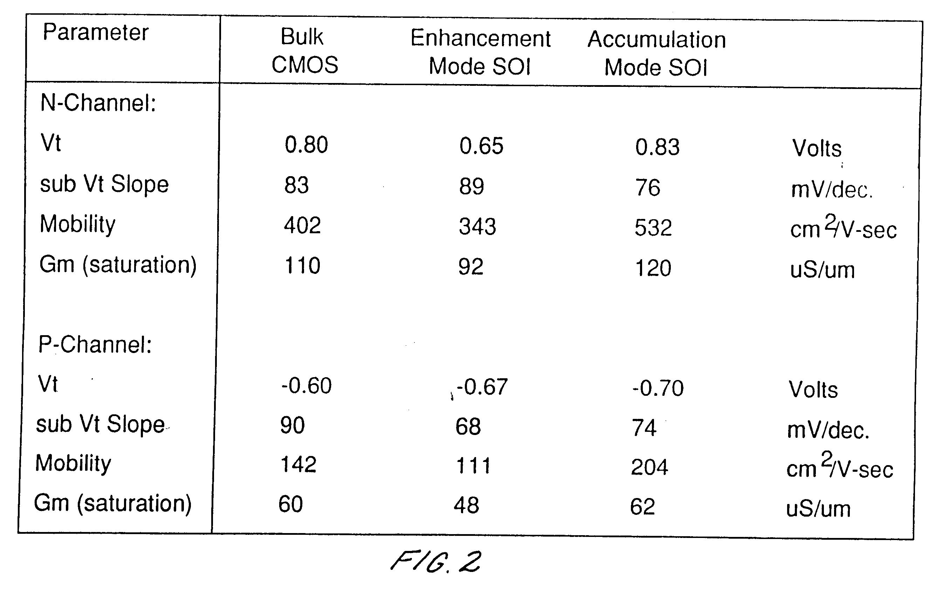

A comparison of bulk, enhancement, and accumulation device types is shown in Figure 2. It can be seen that in order to achieve bulk like threshold voltages, the enhancement mode technology suffers from reduced transconductance and mobility. Also, not shown is the great sensitivity of enhancement devices to dopant concentration and film thickness.

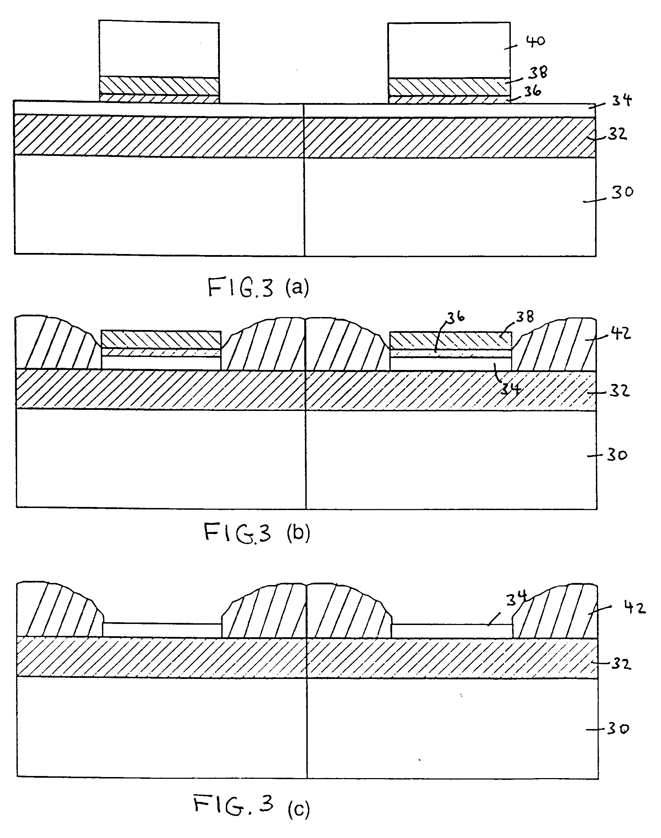

The start of the fabrication process flow to hardening commercial VLSI circuits against single event upset is shown in Figure 3. Shown in Figure 3a is a substrate 30, buried oxide 32, silicon layer 34, which has a pad oxide 36 and a nitride layer 38 with a photo defined region 40. The etched pad stack to open areas where isolation is to be grown is shown in Figure 3b wherein isolation regions 42 are formed between the nitride etched pad stack. Once the local oxidation on the order of 240 - 300 nm 42 is grown, the pad oxide 36 and nitride layer 38 are stripped away.

A sacrificial oxidation on the order of 40 - 80 nm is grown on the silicon region 34 and stripped away to eliminate any stress induced damage from the pad stack. An extra optional photo level may be used to etch alignment marks into the substrate.

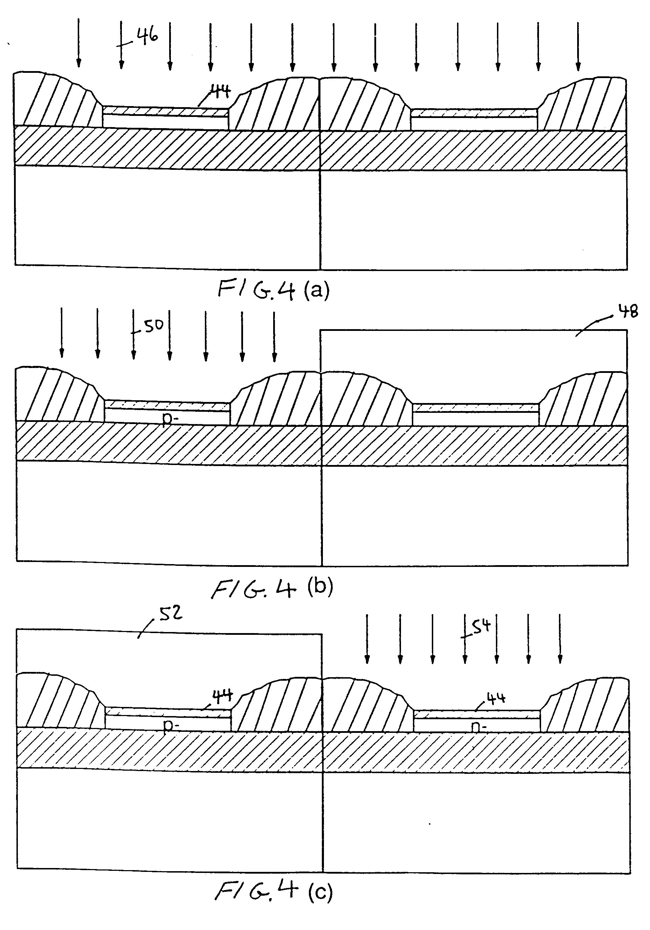

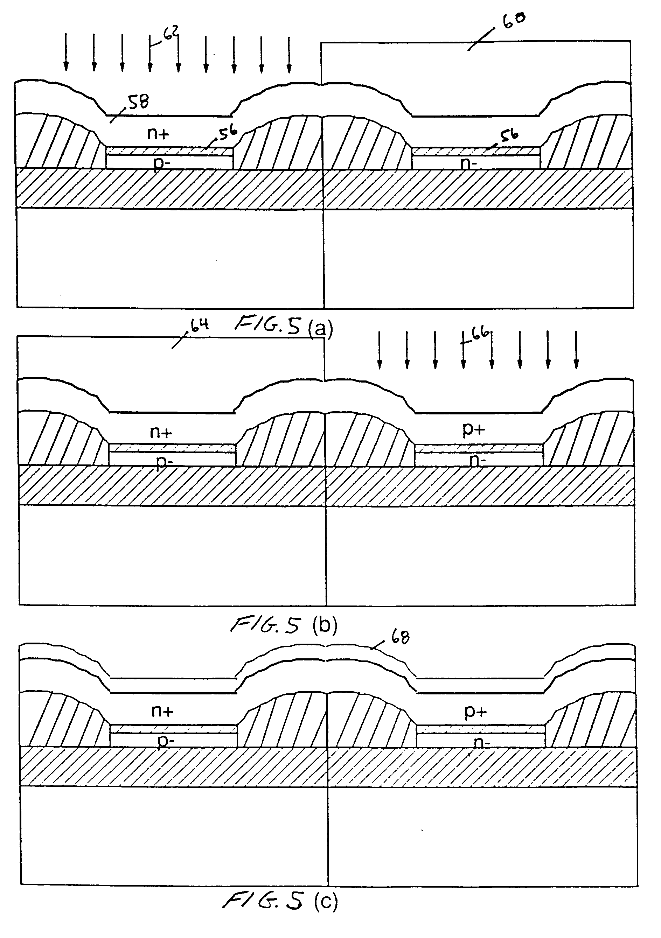

Shown in Figure 4a, is the next step which has a thin oxide growing on it as a sacrificial oxide for ion implantation. Next, a blanket implantation of a neutral impurity ions shown as 46 is blanket implanted over the entire surface of the wafer. Then ina photolithographic step, photo-resist 48 is covered over the n - channel areas and a p - channel threshold adjustment implant 50 is performed in the p - channel region (Figure 4b). Succeeding, the p - channel areas are covered with photo-resist 52 and an implant 54 is done to set the threshold voltage for the n type dopant (Figure 4c). The resist is removed and the sacrificial oxide 44 is removed.

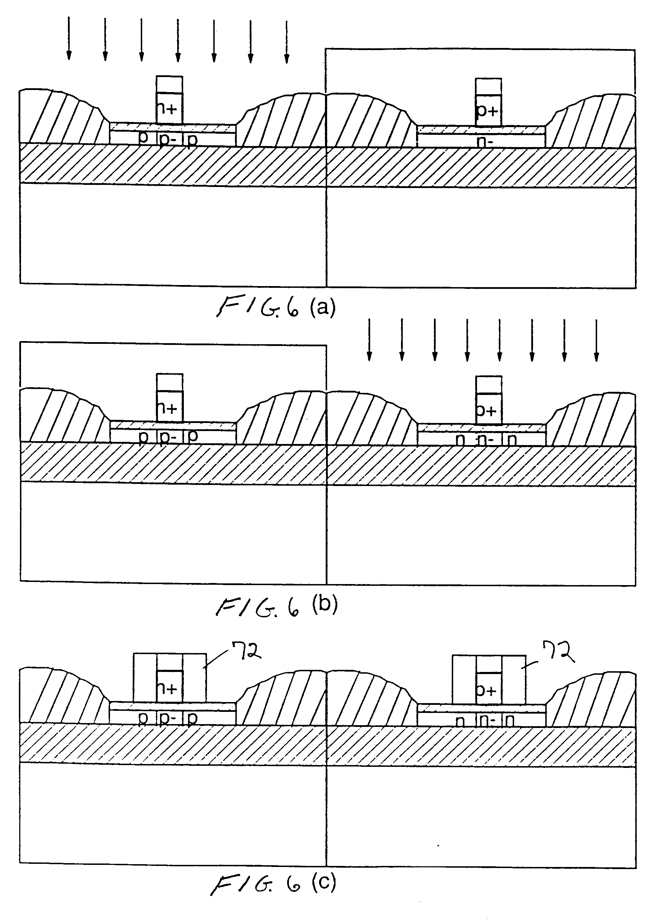

Gate oxide is grown over the p and n channel regions as shown in Figure 5a. This gate oxide 56 is the final gate oxide. Covering the gate oxide is a deposition of polysilicon 58 which is used to form the gate electrode material. A very thin oxide is grown on the polysilicon layer to protect the polysilicon. The n-channel areas are covered with resist 60 and the polysilicon for the p-channel devices is doped with phosphorous implant ions 62. Next, the resist from the n-channel region is removed and resist 64 is coated over the p-channel region with ion implantation 66 of boron (Figure 5b). If boron ions are used, then to minimize the boron penetration from the p+ poly into the device, 10 kV boron should be implanted, rather than the usual boron difluoride (BF2) implant.

A nitride cap 68 is deposited over the entire surface of the wafer (Figure 5c). This nitride cap has a thickness of approximately 115 nm and is used to enhance the slope of the polysilicon gate during its etching and to protect the polysilicon doping from being changed during the diffusion implants.

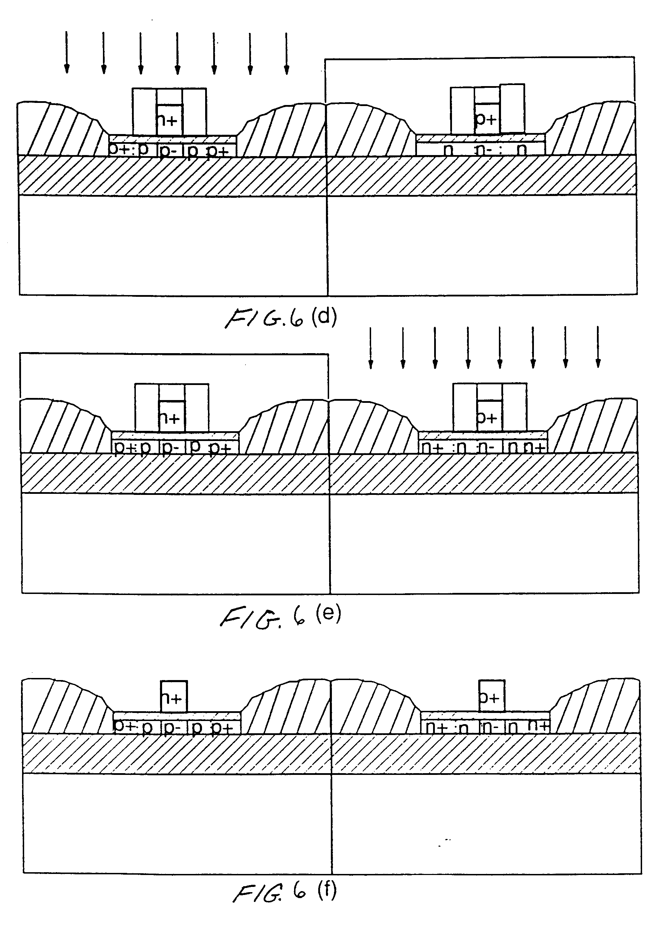

Once the preceding steps are completed, further typical process steps are performed to complete the actual devices. This is done by defining as shown in Figure 6a, the polysilicon gate where the poly is to be etched using photoresist, and proceeding to etchback the gate stack down to (but not including) the gate oxide. With the polysilicon gates defined an LDD implant can be formed in both the p-channel devices as shown in 6a and performing a low dose LDD implant on the n-channel devices using an n type dopant. Next, the n-channel devices can be coated with resist to form a light doped drain (LDD) implant on the p-channel devices using a p type dopant (Figure 6b). Next, silicon nitride can be deposited and etched back in an anisotropic etch to form a nitride implant spacer 72 (Figure 6c). With the implant spacer, the p-channel devices are covered with the resist and the high dose diffusion implant on n-channel devices is performed using a n type dopant (Figure 6d). This is followed by an anneal to activate the dopants and reduce implant damage. Next, the n- channel devices are coated with resist and the integrated circuit implanted with a high dose diffusion implant on the p-channel devices using a p type dopant (Figure 6e). This is annealed to activate the dopant and reduce implant damage. Then the nitride spacer and nitride cap are stripped with hot phosphoric acid (Figure 6f).

Upon completion of the devices, a final spacer and salicide formation in the source drain regions in the back end of the line processing can be completed to form the metalized devices. In the process flow it is assumed that all photoresist are stripped off immediately after the following etch or implant step.

The device definition stage listed above is strictly for the example of LOCOS isolation process described. The critical steps for forming fully depleted accumulation mode devices with device engineering are contained in the stages after device definition. Thus, the use of a different isolation scheme, that is trench, mesa, or other, does not constitute a separate invention. The LDD implant/spacer sequence is optional, and is only required to meet leakage requirements for higher power supply voltages and shorter gate lengths. Depending upon the gate length and/or power supply requirements, the LDD implant on both the n - and p - channel transistors can be varied or eliminated.

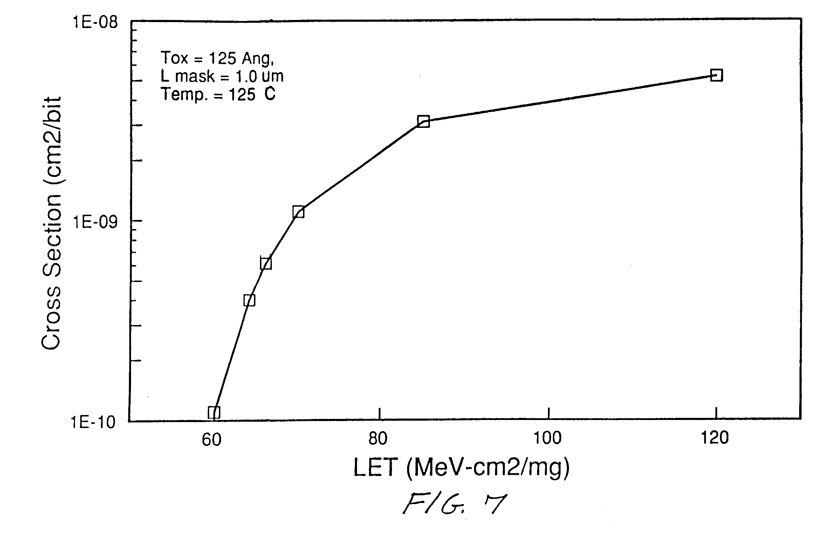

An example of operation as in the above process has built fully functional 256k SRAMs on multiple lots. Testing of these has resulted in radiation hardness as shown in Figure 7, showing an upset rate less than 1E-10 errors/bit*day. This upset level meets military and space product specifications.

## Claims

1. A method of forming radiation hardened circuits from non-radiation hardened circuit designs comprising the steps of:
forming fully depleted transistors (16, 18, 20, 22, 24) in a silicon-on-insulator structure (10, 12) and using non-radiation hardened circuit designs;
forming the transistors with polysilicon gate electrodes of opposite doping tape compared to the doping of the transmitter body and the source and drain doping, to operate as accumulation mode devices,
wherein the circuits are formed on a silicon-on-insulator structure (10, 12) having a silicon thickness (10) of less than 0.1 micrometer.

2. The method of claim 1 wherein the transistors are formed using a lightly doped drain (18) structure.

3. A radiation hardened circuit
with non-radiation hardened circuit design
in a silicon-on-insulator structure (10,12)
comprising fully depleted accumulation mode transistors (16, 18, 20, 22, 24)
having polysilicon gate electrodes of opposite doping type compared to the doping of the transmitter body and the source and drain doping,
wherein the silicon-on-insulator structure (10, 12) has a silicon thickness (10) of less than 0.1 micrometer.

4. The circuit of claim 3, wherein the transistors have a lightly doped drain (18) structure.

## Patentansprüche

1. Verfahren zur Herstellung von strahlungsgehärteten Schaltungen mit nichtstrahlungsgehärteten Schaltungsdesigns, das beinhaltet die Schritte:
Herstellen von vollständig verarmten Transistoren (16, 18, 22, 24) in einer Silizium-auf-Isolatorstruktur (10,12) unter Verwendung von nichtstrahlungsgehärteten Schaltungsdesigns;
Herstellen der Transistoren mit Polysilizium-Gatterelektroden von im Vergleich zu der Dotierung des Transistorkörpers und der Quellen- und Senkendotierung entgegengesetztem Dotierungstyp, so daß sie als Anreicherungsmodus-Bauelemente funktionieren,
wobei die Schaltungen auf einer Silizium-auf-Isolatorstruktur (10,12) mit einer Siliziumdicke (10) von weniger als 0,1 µm hergestellt werden.

2. Verfahren nach Anspruch 1, bei dem die Transistoren unter Verwendung einer Struktur mit gering dotierter Senke (18) hergestellt werden.

3. Strahlungsgehärtete Schaltung
mit nichtstrahlungsgehärtetem Schaltungsdesign
in einer Silizium-auf-Isolatorstruktur (10,12)
beinhaltend vollständig verarmte Anreicherungsmodus-Transistoren (16, 18, 20, 22, 24)
mit Polysilizium-Gatterelektroden von im Vergleich zu dem Transistorkörper und der Quellen- und Senkendotierung entgegengesetztem Dotierungstyp,
wobei die Silizium-auf-Isolatorstruktur (10,12) eine Siliziumdicke (10) von weniger als 0,1 µm hat.

4. Schaltung nach Anspruch 3, bei der die Transistoren eine Struktur (18) mit leicht dotierter Senke aufweisen.

## Revendications

1. Procédé de formation de circuits durcis aux rayonnements à partir de conceptions de circuits non durcis aux rayonnements comprenant les étapes consistant à :
former des transistors complètement appauvris (16, 18, 20, 22, 24) dans une structure de silicium sur isolant (10, 12), et utiliser des conceptions de circuits non durcis aux rayonnements,
former les transistors avec des électrodes de grille en polysilicium de type de dopage opposé par comparaison au dopage du corps du transistor et au dopage de la source et du drain, afin d'être mis en oeuvre en tant que dispositifs en mode d'accumulation,
dans lequel les circuits sont formés sur une structure de silicium sur isolant (10, 12) présentant une épaisseur de silicium (10) inférieure à 0,1 micromètre.

2. Procédé selon la revendication 1, dans lequel les transistors sont formés en utilisant une structure de drain (18) faiblement dopée.

3. Circuit durci aux rayonnements présentant une conception de circuit non durci aux rayonnements dans une structure de silicium sur isolant (10, 12) comprenant des transistors en mode d'accumulation complètement appauvris (16, 18, 20, 22, 24)
comportant des électrodes de grille en polysilicium de type de dopage opposé par comparaison au dopage du corps du transistor et au dopage de la source et du drain,
dans lequel la structure de silicium sur isolant (10, 12) présente une épaisseur de silicium (10) inférieure à 0,1 micromètre.

4. Circuit selon la revendication 3, dans lequel les transistors comportent une structure de drain (18) faiblement dopée.
